# EUROPÄISCHE PATENTSCHRIFT

(11) **EP 1 604 404 B1**
(45) Veröffentlichungstag und Bekanntmachung des Hinweises auf die Patenterteilung: **22.06.2011**
(21) Anmeldenummer: 03718625.1
(22) Anmeldetag: 19.03.2003
(51) Int. Cl.: H01L 29/24, H01L 29/78, H01L 29/808, H01L 29/812, H01L 29/732, H01L 29/10, H01L 21/04

(54) **HALBLEITERAUFBAU MIT HOCH DOTIERTEM KANALLEITUNGSGEBIET UND VERFAHREN ZUR HERSTELLUNG EINES HALBLEITERAUFBAUS**
SEMICONDUCTOR STRUCTURE COMPRISING A HIGHLY DOPED CONDUCTIVE CHANNEL REGION AND METHOD FOR PRODUCING A SEMICONDUCTOR STRUCTURE
STRUCTURE SEMICONDUCTRICE COMPORTANT UNE ZONE DE CANAL FORTEMENT DOPEE ET PROCEDE POUR PRODUIRE UNE STRUCTURE SEMICONDUCTRICE

(43) Veröffentlichungstag der Anmeldung: 14.12.2005
(73) Patentinhaber: Infineon Technologies AG, 85579 Neubiberg (DE)
(72) Erfinder: ELPELT, Rudolf, 91054 Erlangen (DE); MITLEHNER, Heinz, 91080 Uttenreuth (DE); SCHÖRNER, Reinhold, 91091 Grossenseebach (DE)
(74) Vertreter: Bickel, Michael
(86) Internationale Anmeldenummer: PCT/DE2003/000906
(87) Internationale Veröffentlichungsnummer: WO 2004/084310

(56) Entgegenhaltungen:
- WO-A-02/29900
- DE-A- 19 839 970
- DE-A- 19 900 169
- PATENT ABSTRACTS OF JAPAN vol. 1999, no. 14, 22. Dezember 1999 (1999-12-22) -& JP 11 266017 A (DENSO CORP), 28. September 1999 (1999-09-28)
- PATENT ABSTRACTS OF JAPAN vol. 004, no. 148 (E-030), 18. Oktober 1980 (1980-10-18) & JP 55 099772 A (SEMICONDUCTOR RES FOUND), 30. Juli 1980 (1980-07-30)

## Beschreibung

Zum Versorgen eines elektrischen Verbrauchers mit einem elektrischen Nennstrom wird der Verbraucher üblicherweise über ein Schaltgerät an ein elektrisches Versorgungsnetz geschaltet. Beim Einschaltvorgang und auch im Falle eines Kurzschlusses tritt ein Überstrom auf, der deutlich über dem Nennstrom liegt. Zum Schutz des elektrischen Verbrauchers muss das zwischen den Verbraucher und das elektrische Netz geschaltete Schaltgerät diesen Überstrom begrenzen und auch abschalten können. Weiterhin gibt es beispielsweise in der Umrichtertechnik Anwendungen, bei denen der Verbraucher im Falle einer in Sperrrichtung anliegenden Spannung auch sicher vom Versorgungsnetz getrennt werden soll. Für die beschriebenen Funktionen sind strombegrenzende Schalter in Form eines Halbleiteraufbaus bekannt.

So wird in der US 6,034,385 und auch in der WO 00/16403 A1 ein Halbleiteraufbau beschrieben, bei dem ein Stromfluss zwischen einer ersten und einer zweiten Elektrode gesteuert wird. Insbesondere kann der Strom ein- und ausgeschaltet oder auf einen maximalen Wert begrenzt werden. Der aktive Teil des Halbleiteraufbaus besteht aus einem ersten Halbleitergebiet eines vorgegebenen Leitungstyps, insbesondere des n-Leitungstyps. Der Leitungstyp wird bestimmt durch den Typ der Ladungsträger, mit denen das Halbleitergebiet dotiert ist. Zur Stromsteuerung ist innerhalb des ersten Halbleitergebiets mindestens ein laterales Kanalgebiet vorgesehen. Unter lateral oder auch horizontal wird hierbei eine Richtung parallel zu einer Hauptoberfläche des ersten Halbleitergebiets verstanden. Vertikal wird dagegen eine senkrecht zur Hauptoberfläche verlaufende Richtung bezeichnet. Das laterale Kanalgebiet wird durch mindestens einen p-n-Übergang, insbesondere durch die Verarmungszone (Zone mit Verarmung an Ladungsträgern und damit hohem elektrischen Widerstand; Raumladungszone) dieses p-n-Übergangs, in vertikaler Richtung begrenzt. Die vertikale Ausdehnung dieser Verarmungszone kann unter anderem durch eine Steuerspannung eingestellt werden. Der p-n-Übergang ist zwischen dem ersten Halbleitergebiet und einem vergrabenen p-leitenden Inselgebiet gebildet. Das vergrabene Inselgebiet übernimmt die Abschirmung der ersten Elektrode gegenüber dem hohen elektrischen Feld in Sperrrichtung oder im ausgeschalteten Zustand. Bei speziellen Ausführungsformen kann das Kanalgebiet auch durch eine weitere Verarmungszone in vertikaler Richtung begrenzt werden. Diese weitere Verarmungszone wird beispielsweise durch einen weiteren p-n-Übergang zwischen einem zweiten p-leitenden Halbleitergebiet und dem ersten n-leitenden Halbleitergebiet hervorgerufen. Auch das zweite p-leitende Halbleitergebiet kann mittels einer Steuerelektrode an eine Steuerspannung angeschlossen sein. Das für die Stromsteuerung maßgebliche Kanalgebiet ist innerhalb einer Epitaxieschicht angeordnet. Bei der Herstellung dieser Epitaxieschicht kann es zu Schwankungen in der Dicke und der Dotierstoffkonzentration kommen. Dies wirkt sich unmittelbar auf die Strom steuernden Eigenschaften des Kanalgebiets aus. Es ist daher möglich, dass der Halbleiteraufbau am Ende des Herstellungsprozesses aufgrund der Toleranzen der Epitaxieschicht nicht das geforderte Stromsteuerungsverhalten, beispielsweise eine bestimmte Abschnürspannung, aufweist. Dadurch sinkt die erzielbare Ausbeute.

Ein ähnlicher Halbleiteraufbau wird in der DE 196 29 088 A1 beschrieben. Folglich kann es auch bei diesem Halbleiteraufbau zu einer ähnlich niedrigen technologiebedingten Ausbeute bei der Herstellung kommen.

Mit der US 6,232,625 wird eine passive Ausführungsform des vorstehend beschriebenen Halbleiteraufbaus nach der US 6,034,385 offenbart. Das zweite p-leitende Halbleitergebiet ist auch an die erste Elektrode angeschlossen. Dann resultiert ein Aufbau ohne aktive Stromsteuerung, d.h. der Stromfluss durch den Halbleiteraufbau lässt sich nicht durch eine externe Steuerspannung beeinflussen. Der offenbarte Halbleiteraufbau ist vielmehr ein passiver Strombegrenzer.

Weiterhin wird mit der US 5, 543, 637 ein Halbleiteraufbau offenbart, der ein erstes Halbleitergebiet eines ersten Leitungstyps mit einem vergrabenen Inselgebiet eines zum ersten entgegengesetzten Leitungstyps sowie zwei Elektroden und einer Steuerelektrode umfasst. Die durch die Steuerelektrode und das vergrabene Inselgebiet hervorgerufenen jeweiligen Verarmungszonen bilden wieder ein Kanalgebiet, in dem ein zwischen den beiden Elektroden fließender Strom gesteuert wird. Die Steuerelektrode ist entweder als Schottky-Kontakt oder als MOS-Kontakt ausgeführt. Als Halbleitermaterial wird 3C-, 6H oder 4H-Siliciumcarbid (SiC) verwendet. Auch hier ist das Kanalgebiet in einer Epitaxieschicht angeordnet, deren Dicke und Dotierstoffkonzentration Schwankungen unterworfen sind.

Weiterhin ist aus der DE 198 33 214 C1 ein insbesondere in SiC realisierter Halbleiteraufbau bekannt, bei dem zur Stromsteuerung ein von zwei p-leitenden Halbleitergebieten begrenztes n-leitendes laterales Kanalgebiet vorgesehen ist. Wiederum befindet sich das Kanalgebiet in einer Epitaxieschicht, so dass auch hier aus den vorstehend genannten Gründen eine reduzierte Ausbeute bei der Herstellung möglich ist.

In der US 6,150,671 und der US 5,923,051 werden Halbleiteraufbauten jeweils in Form eines SiC-MOSFET's beschrieben. Kanalgebiete befinden sich dabei wiederum in einer p-leitenden bzw. in einer n-leitenden epitaktisch aufgewachsenen Schicht.

Schließlich ist in der DE 199 00 169 A1 ein vertikaler Siliciumcarbid-Feldeffekttransistor und ein Verfahren zu seiner Herstellung angegeben, bei dem in Maskentechnik unterschiedliche Dotierungszonen realisiert werden. Daneben ist aus der WO 02/29900 A2 ein MOS-FET auf Siliciumcarbidbasis bekannt, bei dem ein vertikal orientierter Leitungskanal vorhanden ist. Entsprechendes gilt auch für die JP 11-266017 A, bei der Mittel zur Verminderung des Anlaufwiderstandes auf einem MOS-FET beschrieben werden.

Ausgehend von letzterem Stand der Technik liegt der Erfindung die Aufgabe zugrunde, einen Halbleiteraufbau der eingangs bezeichneten Art anzugeben, der bei der Herstellung unempfindlich gegenüber technologiebedingten Schwankungen ist und eine hohe Ausbeute ermöglicht. Außerdem soll ein Herstellungsverfahren für einen solchen Halbleiteraufbau angegeben werden.

Zur Lösung der den Halbleiteraufbau betreffenden Aufgabe wird ein Halbleiteraufbau entsprechend den Merkmalen des unabhängigen Patentanspruchs 1 angegeben. Ein zugehöriges Herstellungsverfahren ist im Patentanspruch 12 angegeben. Weiterbildungen des Halbleiteraufbaus sind Gegenstand der abhängigen Ansprüche.

Die Erfindung beruht auf der Erkenntnis, dass durch eine zusätzlich in dem Kanalgebiet vorgesehene Zone mit einer verglichen mit dem restlichen Kanalgebiet höheren Dotierstoffkonzentration die Empfindlichkeit des Halbleiteraufbaus gegenüber technologiebedingten Schwankungen bei der Herstellung erheblich reduziert, wenn nicht sogar vollständig beseitigt werden kann. Die zusätzlich vorgesehene Zone, die hier als Kanalleitungsgebiet bezeichnet wird, ist mit Dotierstoffen vom gleichen Ladungsträgertyp (n oder p) wie auch das Kanalgebiet dotiert. Sie bestimmt im Wesentlichen die elektri-schen Eigenschaften des Kanalgebiets. So wird der Strom im Durchlassbetrieb aufgrund der höheren Dotierung und der damit einhergehenden höheren Leitfähigkeit bevorzugt in dem Kanalleitungsgebiet geführt. Das restliche Kanalgebiet bleibt dagegen weitgehend stromfrei, so dass hier etwa vorhandene Schwankungen der Grunddotierung oder der Dicke dann keine oder nur noch eine untergeordnete Rolle spielen. Das Kanalleitungsgebiet kann beispielsweise mittels einer Ionenimplantation mit sehr hoher Genauigkeit und geringen Schwankungen in der Dotierstoffkonzentration sowie der Dicke hergestellt werden. Durch diese so gewonnene neue Unabhängigkeit gegenüber den technologiebedingten Schwankungen ergibt sich eine erhöhte Ausbeute beim Herstellungsprozess des Halbleiteraufbaus.

Vorteilhafte Ausgestaltungen des Halbleiteraufbaus gemäß der Erfindung ergeben sich aus den vom Anspruch 1 abhängigen Ansprüchen.

Bei einer günstigen Ausführungsform enthält das Kanalleitungsgebiet mindestens 80 % der insgesamt in dem Kanalgebiet vorhandenen Gesamtladung des ersten Leitungstyp. Damit sind höchstens nur noch die restlichen 20 % der Gesamtladung, die sich außerhalb des Kanalleitungsgebiets im Kanalgebiet befinden, den technologiebedingten Schwankungen unterworfen. Dieser positive Effekt lässt sich weiter steigern, indem sogar mindestens 90 % der innerhalb des Kanalgebiets vorhandenen Gesamtladung des ersten Leitungstyps im Kanalleitungsgebiet vorgesehen sind.

Günstig ist ein sogenannter vertikaler Halbleiteraufbau, bei dem der Strom im Wesentlichen in vertikaler Richtung durch den Halbleiteraufbau geführt wird. Diese Ausführungsform ist in der Lage, im Sperrfall eine besonders hohe Sperrspannung zu tragen. Grundsätzlich ist jedoch auch ein lateraler Halbleiteraufbau mit im Wesentlichen in lateraler Richtung durch den Halbleiteraufbau verlaufenden Stromfluss möglich.

Die Stromsteuerung erfolgt mittels eines vorzugsweise lateralen Kanalgebiets. In dieser Ausführungsform kann sowohl der zu führende Strom sicher an- und abgeschaltet werden, als auch eine hohe Sperrspannung vom Halbleiteraufbau aufgenommen werden.

Bei einer weiteren bevorzugten Variante liegt der Halbleiteraufbau in Form eines Feldeffekttransistors, insbesondere in Form eines Sperrschicht-Feldeffekttransistors (JFET), vor. Diese Transistorart eignet sich besonders gut für die im Zusammenhang mit der vorliegenden Erfindung gewünschte Stromsteuerung.

In einer vorteilhaften Ausgestaltung besteht der Halbleiteraufbau teilweise oder auch komplett aus einem Halbleitermaterial, das einen Bandabstand von wenigstens 2 eV aufweist. Geeignete Halbleitermaterialien sind beispielsweise Diamant, Galliumnitrit (GaN), Indiumphosphit (InP) oder vorzugsweise Siliciumcarbid (SiC). Auf Grund der extrem niedrigen intrinsische Ladungsträgerkonzentration (= Ladungsträgerkonzentration ohne Dotierung) und des sehr geringen Durchlassverlusts sind die genannten Halbleitermaterialien, insbesondere SiC, sehr vorteilhaft. Die genannten Halbleitermaterialien weisen außerdem im Vergleich zu dem "Universalhalbleiter" Silicium eine deutlich höhere Durchbruchsfestigkeit auf, so dass der Halbleiteraufbau bei einer höheren Spannung eingesetzt werden kann. Das bevorzugte Halbleitermaterial ist Siliciumcarbid, insbesondere einkristallines Siliciumcarbid vom 3C- oder 4H-oder 6H- oder 15R-Polytyp.

Der Halbleiteraufbau weist ein innerhalb des ersten Halbleitergebiets zumindest teilweise vergrabenes Inselgebiet auf. Dieses Inselgebiet hat einen zweiten gegenüber dem ersten Leitungstyp (n oder p) entgegengesetzten Leitungstyp (p oder n). Das Inselgebiet bildet mit dem ersten Halbleitergebiet einen p-n-Übergang, dessen Verarmungszone zur Steuerung des Kanalgebiets und damit auch des Stromflusses herangezogen werden kann.

Bei einer anderen vorteilhaften Ausführungsform ist innerhalb des Kanalleitungsgebiets mindestens ein Kanalkompensationsgebiet angeordnet. Vorzugsweise enthält das Kanalleitungsgebiet mehrere dieser Kanalkompensationsgebiete. Das Kanalkompensationsgebiet weist insbesondere eine Dotierung mit einem zweiten gegenüber dem ersten Leitungstyp (n oder p) entgegengesetzten Leitungstyp (p oder n) auf. Die in den Kanalkompensationsgebieten vorhandene Ladung kompensiert bei anliegender Sperr-Steuerspannung die im Kanalleitungsgebiet vorhandene Ladung, so dass die Dotierstoffkonzentration des ersten Ladungsträgertyps im Kanalleitungsgebiet weiter erhöht werden kann. Dank der Kompensation führt dies nicht zu einer Verschlechterung des elektrischen Verhaltens des Halbleiteraufbaus, insbesondere nicht zu einer unerwünschten Erhöhung der zur vollständigen Abschnürung des Kanalgebiets erforderlichen Steuerspannung (= Abschnürspannung). Dies bietet insbesondere dann Vorteile, wenn eine kleine Abschnürspannung beispielsweise von unter 15 V gefordert ist. Ab einer Erhöhung der Dotierstoffkonzentration des ersten Leitungstyps im Kanalleitungsgebiet um mindestens den Faktor 2 verglichen mit der Ausführungsform ohne Kanalkompensationsgebiete wird der durch die Kompensationsgebiete bedingte Flächenverlust aufgrund der dann erheblich gesteigerten Leitfähigkeit im Kanalleitungsgebiet zumindest wettgemacht, wenn nicht sogar überkompensiert.

Vorteilhaft ist es, wenn das mindestens eine Kanalkompensationsgebiet oder, im Fall mehrerer Kanalkompensationsgebiete, die einzelnen Kanalkompensationsgebiete jeweils eine höhere Dotierstoffkonzentration als das Kanalleitungsgebiet hat bzw. haben. Der Flächenanteil des Kanalleitungsgebiets ist dann größer als der aller Kanalkompensationsgebiete. Dies ist günstig, da der Strom innerhalb des Kanalleitungsgebiets geführt werden soll und deshalb auch ein möglichst großer Anteil des Kanalleitungsgebiets hierfür verfügbar sein sollte. Gleichzeitig bleibt die beschriebene vorteilhafte kompensierende Wirkung im Sperrfall erhalten.

Bevorzugt ist eine Ausgestaltung, bei der die in dem Kanalleitungsgebiet insgesamt vorhandene Gesamtladung des ersten Leitungstyps in etwa gleich groß ist wie die in allen Kanalkompensationsgebieten vorhandene Gesamtladung des zweiten Leitungstyps. Dann wird eine sehr gute Kompensationswirkung erreicht.

Bei einer anderen vorteilhaften Variante ist das Kanalgebiet innerhalb einer Epitaxieschicht angeordnet. Die technologiebedingten Schwankungen der Dotierstoffkonzentration und der Dicke innerhalb der Epitaxieschicht spielen aufgrund des zusätzlich vorhandenen Kanalleitungsgebiets aus den vorstehend genannten Gründen keine Rolle. Weiterhin ist es möglich, dass das erste Halbleitergebiet eine zweite Epitaxieschicht aufweist, die insbesondere als eine im Sperrfall einen wesentlichen Teil der anliegenden Sperrspannung aufnehmende Driftzone ausgebildet ist. Die beiden Epitaxieschichten erfüllen jeweils unterschiedliche Aufgaben. Die eine dient der Stromsteuerung, die andere der Sperrspannungsaufnahme. Günstigerweise können dennoch beide Epitaxieschichten bei einer weiteren Variante eine im Wesentlichen gleiche Grunddotierung aufweisen. Dank des das Stromsteuerungsverhalten maßgeblich bestimmenden Kanalleitungsgebiets kann die Grunddotierung der Epitaxieschicht, in der das Kanalgebiet angeordnet ist, nach anderen Gesichtspunkten ausgelegt werden. Günstig ist es nämlich, wenn es an der Grenzfläche zwischen den beiden Epitaxieschichten zu keinem Dotierungssprung kommt. Der Halbleiteraufbau kann dann eine höhere Sperrspannung tragen.

Weiterhin gibt es eine Variante, bei der das erste Halbleitergebiet auf einem Substrat angeordnet ist, das den zum ersten Leitungstyp entgegengesetzten Leitungstyp aufweist. Dann sind an der Stromführung beide Ladungsträgertypen - Elektronen und Löcher - beteiligt. Aufgrund der bipolaren Modulation stellt sich ein sehr günstiges Stromleitungsverhalten ein. Außerdem bedingt der zusätzliche p-n-Übergang zwischen dem ersten Halbleitergebiet und dem Substrat eine Eignung für eine hohe Sperrspannung.

Grundsätzlich lässt sich das Kanalleitungsgebiet sowohl bei einem selbstleitenden als auch bei einem selbstsperrenden Halbleiteraufbau mit Vorteil einsetzen.

Zur Lösung der das Verfahren betreffenden Aufgabe wird ein Verfahren entsprechend den Merkmalen des Anspruchs 12 angegeben.

Dieses Verfahren ist insbesondere deshalb vorteilhaft, da sich mittels eines Epitaxieverfahrens üblicherweise nur eine Grunddotierung mit einer relativ hohen Schwankungsbreite beispielsweise von etwa ± 15 %, herstellen lässt. Mittels einer Ionenimplantation, die zur Herstellung des Kanalleitungsgebiets eingesetzt wird, lässt sich die Dotierung dagegen wesentlich genauer einstellen. Das Kanalleitungsgebiet, das für die Stromsteuerung maßgeblich ist, hat dann nur eine sehr geringe Schwankung in seiner Dotierstoffkonzentration.

Günstig ist es außerdem, wenn die beiden Epitaxieschichten im Wesentlichen die gleiche Grunddotierung aufweisen. Die Ionenimplantation des Kanalleitungsgebiets findet nach Abschluss der epitaktischen Verfahrensschritte zum Aufbringen der beiden Epitaxieschichten statt. Dieses Verfahren ermöglicht bei hoher Ausbeute die Herstellung eines zur Stromsteuerung bestimmten Halbleiteraufbaus, der insbesondere die vorstehend genannten Vorzüge aufweist.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Merkmale sind schematisiert dargestellt. Im Einzelnen zeigen:
- Figur 1 und Figur 2: einen Halbleiteraufbau mit einem inner- halb eines Kanalgebiets angeordneten hoch dotierten Kanalleitungsgebiet und
- Figur 3: Dotierungsprofil des im Halbleiteraufbau von Figur 1 und 2 vorgesehenen Kanallei- tungsgebiets,
- Figur 4: einen weiteren Halbleiteraufbau mit Ka- nalleitungsgebiet und Kanalkompensa- tionsgebieten,
- Figur 5: einen Querschnitt durch das Kanallei- tungsgebiet und die Kanalkompensations- gebiete des Halbleiteraufbaus von Figur 4 und
- Figur 6 bis Figur 8: einen weiteren Halbleiteraufbau mit Ka- nalleitungsgebiet.

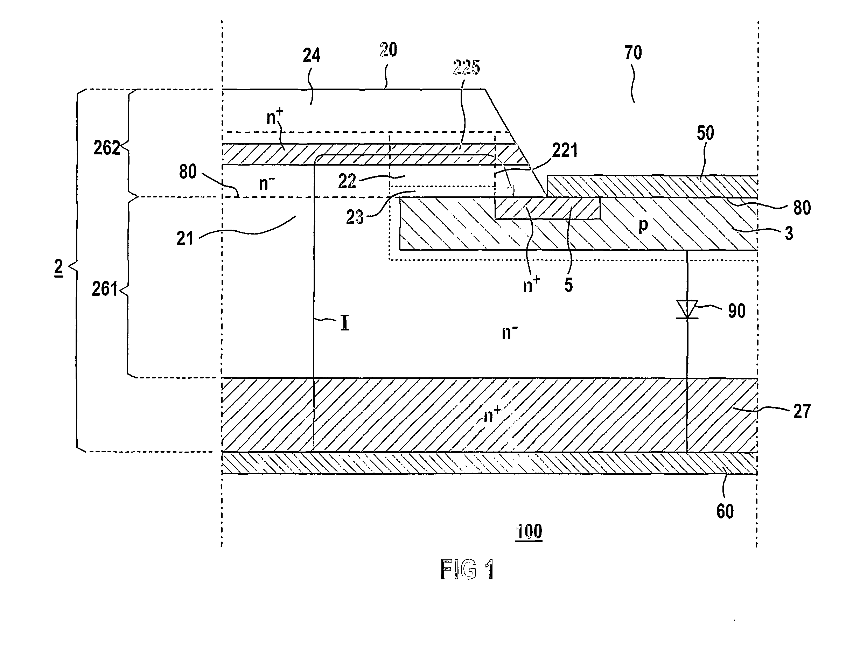

Einander entsprechende Teile sind in den Figuren 1 bis 8 mit denselben Bezugszeichen versehen.

In Figur 1 ist ein Halbleiteraufbau 100 zur Steuerung eines Stroms I in Form eines vertikalen Sperrschicht-FeldeffektTransistors (JFET) dargestellt. Der in Figur 1 gezeigte Halbleiteraufbau ist lediglich eine Halbzelle. Durch Spiegelung an dem rechten Rand der Halbzelle erhält man eine komplette Zelle. Eine Mehrzellenstruktur ergibt sich entsprechend durch mehrfache Spiegelung.

Der aktive Teil, in dem die Stromsteuerung im Wesentlichen stattfindet, ist in einem n-leitenden (Elektronenleitung) ersten Halbleitergebiet 2 enthalten. Innerhalb des ersten Halbleitergebiets 2 ist ein p-leitendes (Löcherleitung) vergrabenes Inselgebiet 3 angeordnet. Das erste Halbleitergebiet 2 weist eine erste Oberfläche 20, das vergrabene Inselgebiet 3 eine zweite Oberfläche 80 auf. Beide Oberflächen 20 und 80 laufen im Wesentlichen parallel zueinander. Das erste Halbleitergebiet 2 setzt sich im Ausführungsbeispiel von Figur 1 aus einem Halbleitersubstrat 27 und zwei darauf angeordneten, epitaktisch aufgewachsenen Halbleiterschichten 261 und 262 zusammen. Die erste Oberfläche 20 gehört zur zweiten Epitaxieschicht 262 und die zweite Oberfläche 80 zur ersten Epitaxieschicht 261. Die beiden Epitaxieschichten 261 und 262 weisen im Wesentlichen eine gleiche Grunddotierung auf. Sie sind niedriger dotiert (n⁻) als das Halbleitersubstrat 27 (n⁺).

An der zweiten Oberfläche 80 ist ein innerhalb des Inselgebiets 3 eingebettetes n-leitendes Kontaktgebiet 5 vorgesehen. Es ist hoch dotiert (n⁺). Das Inselgebiet 3 erstreckt sich in allen Richtungen parallel zur ersten Oberfläche 20 weiter als das Kontaktgebiet 5.

Als Halbleitermaterial kommt in dem Halbleiteraufbau 100 Siliciumcarbid (SiC) zum Einsatz. Es eignet sich insbesondere bei hohen Spannungen auf Grund seiner spezifischen Materialeigenschaften besonders gut. Bevorzugte Dotierstoffe sind Bor und Aluminium für eine p-Dotierung sowie Stickstoff und Phosphor für eine n-Dotierung. Die Dotierstoffkonzentration des Kontaktgebiets 5 liegt typischerweise zwischen 1x10¹⁹ cm⁻³ und 1x10²⁰ cm⁻³ und die der beiden Epitaxieschichten 261 und 262 typischerweise bei höchstens 5x10¹⁶ cm⁻³. Das Zeichen "x" wird hier als Multiplikationssymbol verwendet. Die Dotierung der ersten Epitaxieschicht 261 hängt insbesondere von der im Sperrfall von dem Halbleiteraufbau 100 aufzunehmenden Sperrspannung ab. Je höher die Sperrspannung ist, desto niedriger liegt diese Dotierung. Die Epitaxieschicht 261 hat im Wesentlichen das zu sperrende elektrische Feld zu tragen. Im gezeigten Beispiel haben beide Epitaxieschichten 261 und 262 eine Grunddotierung von etwa zwischen 5x10¹⁵ cm⁻³ und 7x10¹⁵ cm⁻³. Die Sperrspannung liegt dann mindestens bei 1200 V.

Vorzugsweise werden das vergrabene Inselgebiet 3 und das darin eingebettete Kontaktgebiet 5 nach Aufbringen der ersten Epitaxieschicht 261 hergestellt. Dabei kann insbesondere die in der US 6,204,135 B1 beschriebene selbstjustierende Maskierungstechnik eingesetzt werden. Das Inselgebiet und das Kontaktgebiet 5 werden demgemäss mittels zweier Maskierungsschritte und einer Ionenimplantation von p- bzw. n- Dotierstoffteilchen in die zweite Oberfläche 80 erzeugt. Danach wird in einem zweiten epitaktischen Wachstumsschritt die zweite Epitaxieschicht 262 aufgebracht.

Innerhalb der zweiten Epitaxieschicht 262 ist ein Kontaktloch 70 vorgesehen, das sich in vertikaler Richtung bis zu der zweiten Oberfläche 80 erstreckt. Das Kontaktloch 70 legt sowohl einen Teil des vergrabenen Inselgebiets 3 als auch einen Teil des Kontaktgebiets 5 frei, so dass beide Gebiete 3 und 5 mittels einer ersten Elektrode 50 aus einem elektrisch leitenden Material ohmsch kontaktiert werden können. Das Kontaktgebiet 5 und das Inselgebiet 3 sind durch die erste Elektrode 50 kurz geschlossen. Als Material für die erste Elektrode 50 kommt Polysilicium oder ein Metall, vorzugsweise Nickel, Aluminium, Tantal, Titan oder Wolfram, in Frage. Das Kontaktloch 70 wird beispielsweise mittels eines Trockenätzprozesses hergestellt. Um Schwankungen in der Ätztiefe aus zugleichen, können gemäß einer nicht dargestellten Ausführungsform auch mehrere Kontaktlöcher 70, die dann jeweils einen kleineren Durchmesser aufweisen, vorgesehen sein.

Auf einer von der ersten Oberfläche 20 abgewandten Seite des ersten Halbleitergebiets 2 ist eine zweite Elektrode 60 vorgesehen. Die Zu- und Ableitung des durch den Halbleiteraufbau 100 fließenden Stroms I erfolgt mittels der beiden Elektroden 50 und 60. Auf Grund des im Wesentlichen vertikalen, d.h. senkrecht zur ersten Oberfläche 20 verlaufenden Strompfades wird der Halbleiteraufbau 100 auch als vertikal bezeichnet.

Seitlich (= lateral) neben dem Kontaktloch 70 ist eine an die erste Oberfläche 20 angrenzende erste Verarmungszone 24 angeordnet, die sich innerhalb des ersten Halbleitergebiets 2 befindet. Weiterhin ist zwischen dem ersten Halbleitergebiet 2 und dem vergrabenen Inselgebiet 3 ein p-n-Übergang vorhanden, dessen Verarmungszone hier als zweite Verarmungszone 23 bezeichnet wird. Die zweite Verarmungszone 23 umgibt das gesamte vergrabene Inselgebiet 3. Soweit sich die beiden Verarmungszonen 23 und 24 innerhalb des ersten Halbleitergebiets 2 erstrecken, sind sie in Figur 1 gestrichelt eingezeichnet. Die erste und die zweite Verarmungszone 24 bzw. 23 begrenzen in vertikaler Richtung ein laterales Kanalgebiet 22, das innerhalb des ersten Halbleitergebiets 2 liegt und Teil des Strompfads zwischen der ersten und der zweiten Elektrode 50 bzw. 60 ist. Die erste Verarmungszone 24 und das vergrabene Inselgebiet 3 sind so angeordnet, dass sich die beiden Verarmungszonen 23 und 24 in einer Projektion auf die erste Oberfläche 20 an ihren seitlichen Rändern überlappen. Das laterale Kanalgebiet 22 befindet sich gerade innerhalb dieses Überlappungsbereichs.

In lateraler Richtung ist das laterale Kanalgebiet 22 auf der dem Kontaktloch 70 zugewandten Seite durch einen Rand 221 begrenzt. Dieser Rand 221 wird durch eine senkrecht zur ersten oder zweiten Oberfläche 20 bzw. 80 vorgenommene Projektion des Kontaktgebiets 5 in das erste Halbleitergebiet 2 gebildet. Die als untere vertikale Begrenzung dienende zweite Verarmungszone 23 erstreckt sich nämlich ab der Stelle, an der das stark n-dotierte Kontaktgebiet 5 innerhalb des Inselgebiets 3 angeordnet ist, nicht mehr in das erste Halbleitergebiet 2. Der für eine solche Verarmungszone maßgebliche p-n-Übergang verläuft ab dieser Stelle zwischen dem n-leitenden Kontaktgebiet 5 und dem p-leitenden Inselgebiet 3. Der laterale Rand 221 wird damit durch die Lage des Kontaktgebiets 5 innerhalb des Inselgebiets 3 bestimmt. Der in Figur 1 nicht näher bezeichnete zweite laterale Rand des lateralen Kanalgebiets 22 wird dagegen durch die laterale Abmessung des Inselgebiets 3 bestimmt. Diese Geometrieparameter lassen sich durch das in der US 6,204,135 B1 beschriebene Strukturierungsverfahren sehr genau einstellen.

Die erste Verarmungszone 24 und das Kontaktgebiet 5 sind in Bezug zueinander so angeordnet, dass sie sich in einer senkrecht zur ersten oder zweiten Oberfläche 20 bzw. 80 vorgenommenen Projektion in eine gemeinsame Ebene an ihren seitlichen Rändern um 1 bis 2 µm überlappen. Durch diese letztgenannte Überlappung wird sichergestellt, dass der laterale Rand 221 bis unmittelbar an das Kontaktgebiet 5 heranreicht.

Typischerweise beträgt die Länge (= laterale Ausdehnung) des lateralen Kanalgebiets 22 bei einem aus Siliciumcarbid hergestellten Halbleiteraufbau 100 zwischen 1 µm und 5 µm. Vorzugsweise ist das laterale Kanalgebiet 22 möglichst kurz ausgebildet. Dann ergibt sich ein sehr kompakter Gesamtaufbau mit geringem Platzbedarf. Die vertikale Ausdehnung liegt im spannungs- und stromfreien Zustand typischerweise zwischen 0,5 µm und 2 µm. Die Verarmungszonen 23 und 24 sind durch eine starke Verarmung an Ladungsträgern gekennzeichnet und weisen damit einen wesentlich höheren elektrischen Widerstand auf, als das von ihnen in vertikaler Richtung begrenzte laterale Kanalgebiet 22. Die räumliche Ausdehnung der beiden Verarmungszonen 23 und 24, insbesondere die in vertikaler Richtung, variiert in Abhängigkeit der herrschenden Strom- und Spannungsverhältnisse.

Das laterale Kanalgebiet 22 bestimmt damit maßgeblich das (Steuerungs-)Verhalten des gesamten Halbleiteraufbaus 100. Bei einer Ausbildung als Strombegrenzer hängt das Verhalten bei Anliegen einer Betriebsspannung in Durchlassrichtung (= Vorwärtsrichtung) von dem zwischen den beiden Elektroden 50 und 60 durch den Halbleiteraufbau 100 fließenden elektrischen Strom I ab. Mit steigender Stromstärke wächst auf Grund des Bahnwiderstands der Vorwärtsspannungsabfall zwischen den Elektroden 50 und 60. Dies führt zu einer Vergrößerung der Verarmungszonen 23 und 24 und folglich zu einer mit einer entsprechenden Widerstandserhöhung verbundenen Verminderung der stromtragenden Querschnittsfläche im lateralen Kanalgebiet 22. Bei Erreichen eines bestimmten kritischen Stromwerts (= Sättigungsstrom) berühren sich die beiden Verarmungszonen 23 und 24 und schnüren das laterale Kanalgebiet 22 vollständig ab.

Eine derartige Kanalabschnürung kann auch erreicht werden, indem eine Steuerspannung an den Halbleiteraufbau 100 insbesondere so angelegt wird, dass die erste Verarmungszone 24 in vertikaler Richtung vergrößert wird. Die Steuerspannung, die bei verschwindender Spannung zwischen der ersten und zweiten Elektrode 50 bzw. 60 angelegt werden muss, um eine Kanalabschnürung zu erreichen, nennt man auch Abschnürspannung.

Der Strompfad zwischen der ersten und der zweiten Elektrode 50 bzw. 60 umfasst in Vorwärtsrichtung das Kontaktgebiet 5 das laterale Kanalgebiet 22 ein im ersten Halbleitergebiet 2 angeordnetes vertikales Kanalgebiet 21 sowie eine sich danach anschließende Driftzone, die sich aus dem verbleibenden Teil der ersten Epitaxieschicht 261 und dem Substrat 27 zusammensetzt.

Bei Anlegen einer Betriebsspannung in Rückwärtsrichtung erfolgt der Stromfluss dagegen im Wesentlichen über eine Rückwärtsdiode 90, die durch das vergrabene Inselgebiet 3 und den darunter liegenden Teil des ersten Halbleitergebiets 2 gebildet ist.

Das für die Stromsteuerung maßgebliche laterale Kanalgebiet 22 wird in seinem Verhalten insbesondere durch die zweite Epitaxieschicht 262 bestimmt. Die Eigenschaften der zweiten Epitaxieschicht 262 beeinflussen insbesondere die Abschnürspannung, eine zur Steuerung der ersten Verarmungszone 24 angelegte Spannung, ab der es zu einem Stromfluss zwischen der Verarmungszone 24 und dem vergrabenen Inselgebiet 3 kommt (= Durchgriffspannung), den maximal zwischen den beiden Elektroden 50 und 60 fließenden Strom I (= Sättigungsstrom), den elektrischen Widerstand im Kanalgebiet 22 und auch in gewissem Umfang die maximal zulässige Sperrspannung. Die Eigenschaften der zweiten Epitaxieschicht 262 können nun aber technologiebedingte Schwankungen aufweisen. So schwankt die Dotierstoffkonzentration in der aufgewachsenen zweiten Epitaxieschicht 262. Diese Schwankungen in der Dotierung können um bis zu ± 15 % der Grunddotierung ausmachen. Noch höhere Abweichungen sind ebenfalls möglich. Außerdem kann die Dicke der Epitaxieschicht 262 über dem Querschnitt des Halbleiteraufbaus 100 Schwankungen unterworfen sein. Diese technologiebedingten Schwankungen wirken sich gegebenenfalls negativ auf das gewünschte Verhalten des lateralen Kanalgebiets 22 aus.

Um diesen Einfluss zu beheben, ist in der zweiten Epitaxieschicht 262 ein n-leitendes Kanalleitungsgebiet 225 angeordnet, das sich auch in das Kanalgebiet 22 erstreckt und das insbesondere eine höhere Dotierung als die Grunddotierung der zweiten Epitaxieschicht 262 und der übrige Teil des Kanalgebiets 22 aufweist. Dadurch hat das Kanalleitungsgebiet 225 eine deutlich höhere elektrische Leitfähigkeit als der restliche Teil des Kanalgebiets 22. Im Durchlassbetrieb wird der Strom I im Wesentlichen innerhalb des Kanalleitungsgebietes 225 geführt. Folglich bestimmt auch das Kanalleitungsgebiet 225 weitgehend das Stromsteuerungsverhalten des Halbleiteraufbaus 100.

Das Kanalleitungsgebiet 225 wird mittels Implantation von n-leitenden Dotierstoffteilchen in das zweite Epitaxiegebiet 262 gebildet. Damit lässt sich die Dotierung des Kanalleitungsgebietes 225 sehr exakt einstellen. Insbesondere ergeben sich im Gegensatz zu einer epitaktisch hergestellten Schicht keine vergleichbaren Schwankungen in der Dotierung und der Dicke. Im Kanalleitungsgebiet 225 befindet sich der wesentliche Anteil, d.h. insbesondere mindestens 80 %, der innerhalb des Kanalgebiets 22 vorhandenen Gesamtdotierung an n-leitenden Ladungsträgern. Im gezeigten Beispiel wird die implantierte Dotierstoffkonzentration in dem Kanalleitungsgebiet 225 so gewählt, dass im gesamten Kanalgebiets 22 eine durchschnittliche Dotierstoffkonzentration von etwa 2x10¹⁶ cm⁻³ vorliegt. Dies entspricht einer gängigen Dotierstoffkonzentration, die bei einem nicht gezeigten Halbleiteraufbau ohne Kanalleitungsgebiet 225 gleichmäßig verteilt innerhalb des Kanalgebiets 22 vorhanden ist. Während bei dieser nicht gezeigten Ausführungsform jedoch die epitaxiebedingten Schwankungen der Dotierstoffkonzentration das Verhalten des Kanalgebiets 22 wesentlich beeinflussen, haben die Schwankungen der nun mit einer Grunddotierung von etwa 7x10¹⁵ cm⁻³ versehenen zweiten Epitaxieschicht 262 praktisch keinen Einfluss auf das Stromsteuerungsverhalten des Halbleiteraufbaus 100. Der Hauptteil der im Kanalgebiet 22 vorhandenen Gesamtladung befindet sich im praktisch ohne Dotierungsschwankungen hergestellten Kanalleitungsgebiet 225.

Ein weiterer Vorteil des Halbleiteraufbaus 100 verglichen mit der nicht gezeigten Ausführungsform ohne Kanalleitungsgebiet 225 besteht darin, dass das Kanalleitungsgebiet 225 im Sperrfall einen ansonsten möglichen Felddurchgriff in das Kanalgebiet 22 und eine damit einhergehende Verschiebung der Abschnürspannung zumindest weitgehend oder sogar vollständig verhindert.

Aufgrund des ionenimplantierten Kanalleitungsgebiets 225 lässt sich der Halbleiteraufbau 100 reproduzierbar mit sehr hoher Ausbeute und sehr genau definierten elektrischen Eigenschaften (z.B. Abschnürspannung, Durchgriffspannung, Kanalwiderstand, Sättigungsstrom, Sperrspannung) herstellen. Bedient man sich bei der Fertigung wie üblich eines Halbleiterwafers, um gleichzeitig viele Halbleiteraufbauten 100 herstellen zu können, so wird aufgrund der eingesetzten Ionenimplantation über den kompletten Halbleiterwafer hinweg eine sehr hohe Homogenität der Dotierungen in allen Kanalleitungsgebieten 225 erreicht.

Die Verarmungszone 24, die das Kanalgebiet 22 mit beeinflusst, kann auf verschiedene Weise innerhalb des ersten Halbleitergebiets 2 hervorgerufen werden. Beispielsweise aus der WO 00/16403 A1 bekannte Ausführungsformen hierfür umfassen einen auf der ersten Oberfläche 20 angeordneten Schottky-Kontakt oder MOS(Metal Oxide Semiconductor)-Kontakt.

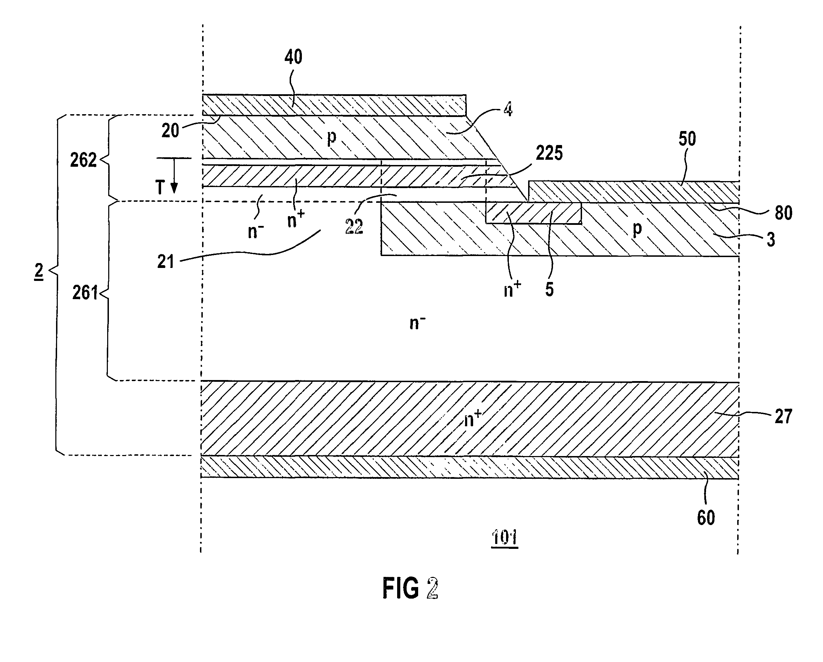

Weiterhin kann auch wie bei einem in Figur 2 gezeigten Halbleiteraufbau 101 ein zweites Halbleitergebiet 4 an der ersten Oberfläche 20 innerhalb des ersten Halbleitergebiets 2 angeordnet sein. Das Halbleitergebiet 4 hat den gegenüber dem ersten Leitungstyp des ersten Halbleitergebiets 2 entgegengesetzten Leitungstyp, also in dem dargestellten Ausführungsbeispiel den p-Leitungstyp. Es wird vorzugsweise durch Ionenimplantation erzeugt. Das zweite Halbleitergebiet 4 ist insbesondere stark p-dotiert (p⁺). Insbesondere weist ein Volumenelement des zweiten Halbleitergebiets 4 eine Gesamtladungsmenge an aktivierten Dotierstoffen auf, die mindestens 5-fach, vorzugsweise mindestens 10-fach höher ist als in einem vergleichbaren Volumenelement des Kanalgebiets 22. Dabei umfasst das Vergleichs-Volumenelement des Kanalgebiets 22 einen Teil mit der Grunddotierung, aber auch einen Teil mit der höheren Dotierung des Kanalleitungsgebiets 225 auf. Zwischen dem ersten Halbleitergebiet 2 und dem zweiten Halbleitergebiet 4 ist ein p-n-Übergang vorhanden, dessen Verarmungszone die in Figur 1 gezeigte Verarmungszone 24 bildet. Aus Gründen der besseren Übersichtlichkeit sind in dem Halbleiteraufbau 101 von Figur 2 keine Verarmungszonen eingetragen. Das zweite Halbleitergebiet 4 ist mit einer Steuerelektrode 40 ohmsch kontaktiert, so dass über eine externe Steuerspannung die Ausdehnung der Verarmungszone 24 und damit der Stromfluss im Kanalgebiet 22 und im Kanalleitungsgebiet 225 beeinflusst werden kann.

Der Halbleiteraufbau 101 ist eine aktiven Anordnung, da der Stromfluss innerhalb des Halbleiteraufbaus 101 durch eine externe Maßnahme (Steuerspannung) beeinflusst werden kann. Es sind jedoch beispielsweise aus der WO 00/16403 A1 auch andere hier nicht gezeigte Ausführungsformen bekannt, die zu einer passiven Stromsteuerung führen und die grundsätzlich ebenfalls mit dem vorteilhaften Kanalleitungsgebiet 225 zur Stromführung und -steuerung kombiniert werden können.

Weiterhin ist der Halbleiteraufbau 101 von Figur 2 eine selbstleitende (= normally on) Struktur. Dies bedeutet, dass bei spannungsloser Steuerelektrode 40 das Kanalgebiet 22 und/oder das Kanalleitungsgebiet 225 offen, also nicht abgeschnürt sind. Bei einer Steuerspannung von Null kann folglich Strom fließen. Nicht dargestellt ist eine grundsätzlich ebenfalls mögliche selbstsperrende (= normally off) Ausführungsform, bei der das Kanalgebiet 22 und das Kanalleitungsgebiet 225 abgeschnürt sind, wenn an der Steuerelektrode 40 keine Steuerspannung ansteht. Die Dicke (= vertikale Abmessung) der zweiten Epitaxieschicht 262 oder des Kanalgebiets 22 ist dann so gewählt, dass die in Figur 1 dargestellten Raumladungszonen 23 und 24, die sich aufgrund der sogenannten Built-In-Potentiale ausbilden, sich gegenseitig mindestens berühren und so das Kanalgebiet 22 und das Kanalleitungsgebiet 225 komplett abschnüren (= pinch off). Um einen Stromfluss zu ermöglichen, wäre dann bei einem dem Halbleiteraufbau 101 von Figur 2 vergleichbaren, aber selbstsperrenden Ausführungsbeispiel eine positive Steuerspannung erforderlich. Auch bei dieser selbstsperrenden Ausführungsform lässt sich das Kanalleitungsgebiet 225 im Wesentlichen mit den gleichen Vorteilen wie bei den selbstleitenden Ausführungsformen einsetzen.

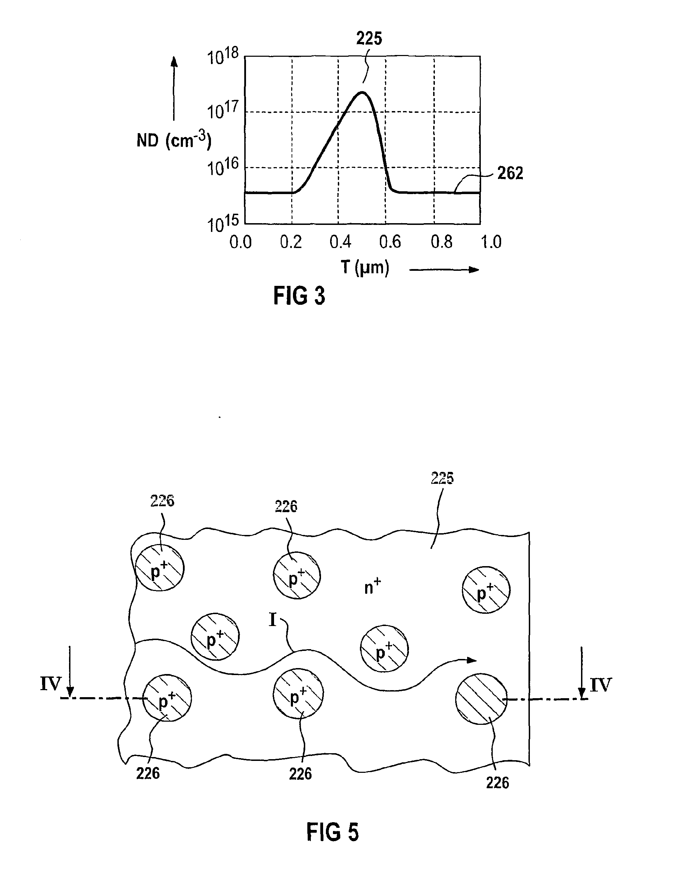

In Figur 3 ist ein typisches Dotierungsprofil für ein Kanalleitungsgebiet 225 dargestellt. In dem Diagramm ist eine Dotierstoffkonzentration ND über einer auch in Figur 2 eingetragenen Tiefe T des Kanalgebiets 22 aufgetragen. Man erkennt die Grunddotierung der zweiten Epitaxieschicht 262 und auch die zusätzliche per Ionenimplantation in das Kanalleitungsgebiet 225 eingebrachte Dotierung.

Durch das Kanalleitungsgebiet 225 erhält man einen zusätzlichen Freiheitsgrad bei der Auslegung des Halbleiteraufbaus 100 oder 101. Das Stromführungsverhalten wird hauptsächlich durch die Dotierung innerhalb des Kanalleitungsgebietes 225 bestimmt, wohingegen die Grunddotierung des restlichen Kanalgebietes 22 und der zweiten Epitaxieschicht 262 diesbezüglich von untergeordneter Bedeutung ist. Damit kann die Grunddotierung nach anderen Gesichtspunkten ausgewählt werden. Insbesondere ist es günstig, wenn die Grunddotierung der zweiten Epitaxieschicht 262 gleich der im Wesentlichen durch die zu tragende Sperrspannung bestimmte Dotierung der ersten Epitaxieschicht 261 ist. Dann ergibt sich kein Dotierungssprung an der Grenzfläche 80 zwischen den beiden Epitaxieschichten 261 und 262. Ein solcher Dotierungssprung könnte andernfalls im Sperrfall zu unerwünschten Feldverzerrungen im Grenzbereich der beiden Epitaxieschichten 261 und 262 führen, wodurch sich eine Einschränkung der maximal nutzbaren Sperrfeldstärke oder der maximal erreichbaren Sperrspannung ergeben könnte.

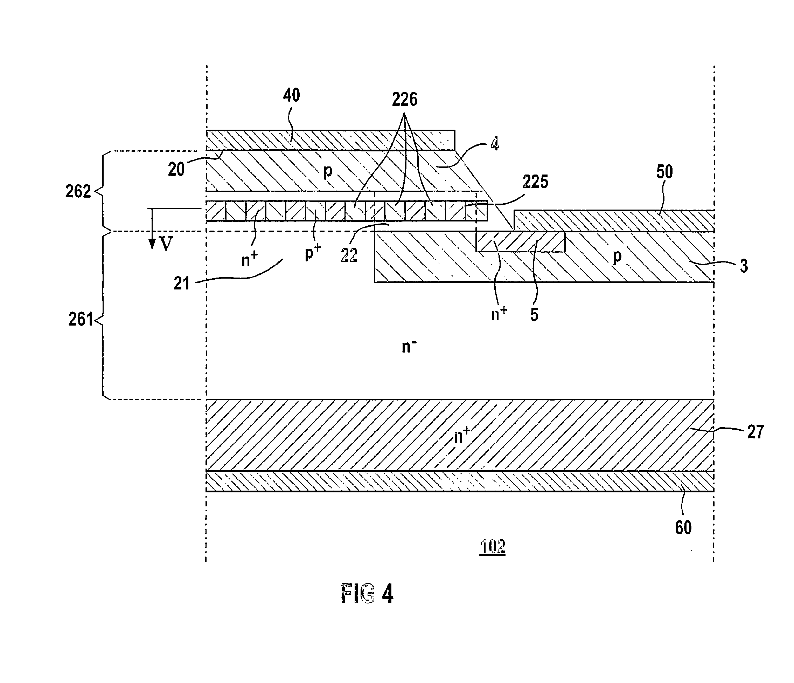

In Figur 4 ist ein besonders günstiger Halbleiteraufbau 102 dargestellt, bei dem die hohe Konzentration an n-leitenden Ladungsträgern im Kanalleitungsgebiet 225 durch p-leitende Kanalkompensationsgebiete 226 zumindest teilweise kompensiert werden. Um eine möglichst gute Stromleitfähigkeit im Kanalleitungsgebiet 225 zu erreichen, ist nämlich eine möglichst hohe Ladungsträgerkonzentration wünschenswert. Andererseits führt eine zu hohe Ladungsträgerkonzentration aber zu einer Erhöhung der an der Steuerelektrode 40 anzulegenden Abschnürspannung, die erforderlich ist, um das Kanalgebiet 22 vollständig abzuschnüren. Aufgrund der in das Kanalleitungsgebiet 225 eingebetteten Kanalkompensationsgebiete 226 kommt es zu keiner unerwünschten Erhöhung der Abschnürspannung, selbst wenn eine sehr hohe Dotierstoffkonzentration innerhalb des Kanalleitungsgebiets 225 vorgesehen ist. Günstigerweise ist die Gesamtladung an p-leitenden Ladungsträgern, die sich innerhalb aller Kanalkompensationsgebiete 226 befinden, in etwa gleich groß wie die Gesamtladung aller n-leitenden Ladungsträger des Kanalleitungsgebiets 225. Um dies zu erreichen, ist die Dotierstoffkonzentration in den p-leitenden Kanalkompensationsgebieten 226 höher als in dem n-leitenden Kanalleitungsgebiet 225. Der Grund hierfür liegt in der größeren Grundfläche des Kanalleitungsgebiets 225 verglichen mit der Grundfläche aller Kanalkompensationsgebiete 226.

Diese Flächenverhältnisse gehen aus der in Figur 5 gezeigten Querschnittsdarstellung des Kanalleitungsgebiet 225 und der Kanalkompensationsgebiete 226 deutlich hervor. Der Verlauf des Stroms I innerhalb des Kanalleitungsgebietes 225 ist in Figur 5 ebenfalls eingezeichnet. Die Querschnittsfläche der Kanalkompensationsgebiete 226 kann außer der dargestellten runden Geometrie auch andere Formen, beispielsweise eine Quadrat- oder eine Streifenform, annehmen.

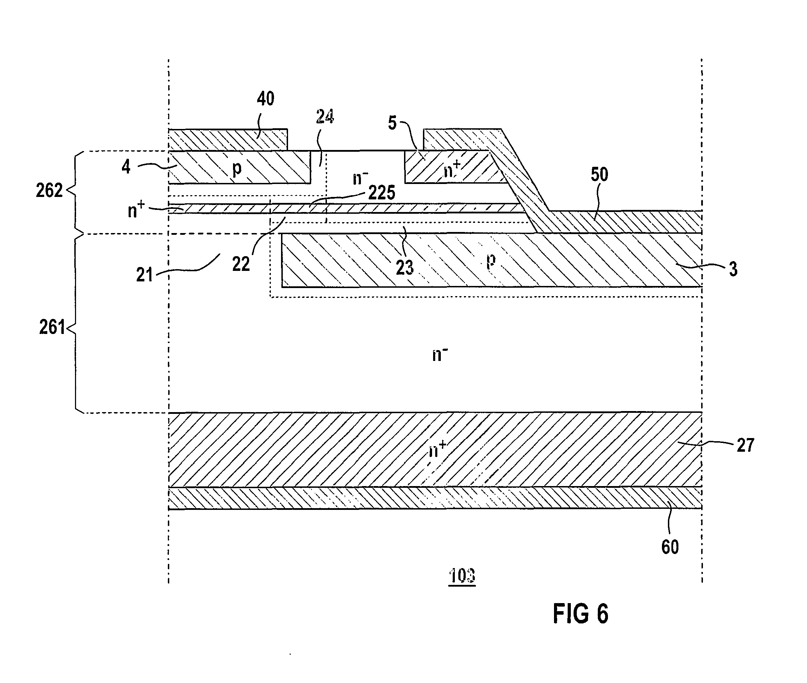

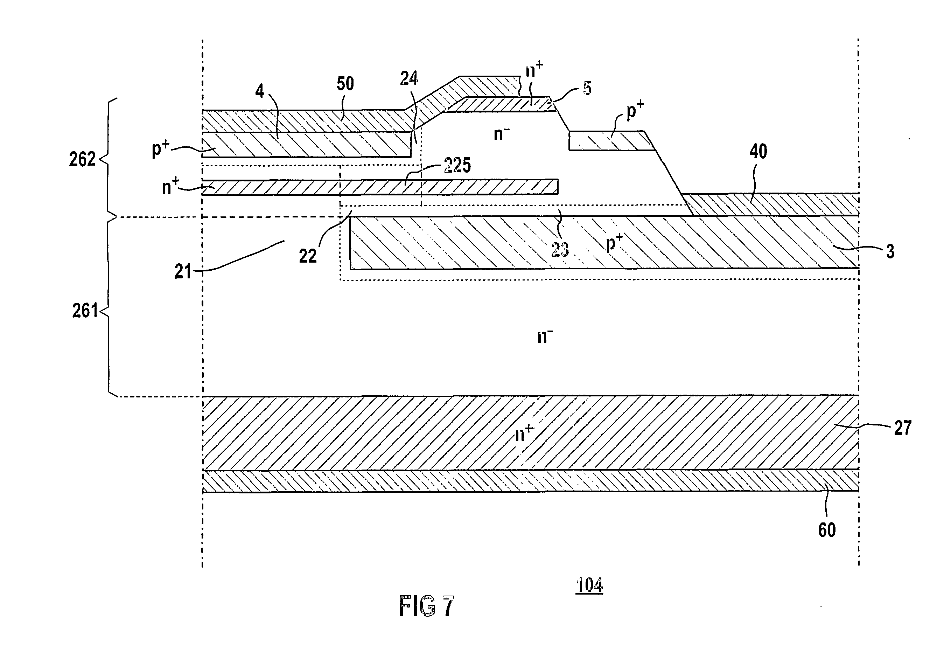

Die vorteilhafte Wirkung des Kanalgebiets 225 kann auch bei anderen grundsätzlich möglichen Ausführungsformen des Halbleiteraufbaus beispielsweise bei einem Halbleiteraufbau 103 gemäß Figur 6 oder bei einem Halbleiteraufbau 104 gemäß Figur 7 mit Vorteil zum Einsatz kommen. Abgesehen von dem Kanalleitungsgebiet 225 ist der Halbleiteraufbau 103 aus der WO 00/16403 A1 und der Halbleiteraufbau 104 aus der DE 198 33 214 C1 bekannt. Genau wie bei den in den vorherigen Figuren offenbarten Halbleiteraufbauten 100, 101 und 102 handelt es sich auch bei den Halbleiteraufbauten 103 und 104 jeweils um einen Sperrschicht-Feldeffekttransistor, die insbesondere in dem Halbleitermaterial SiC realisiert sind.

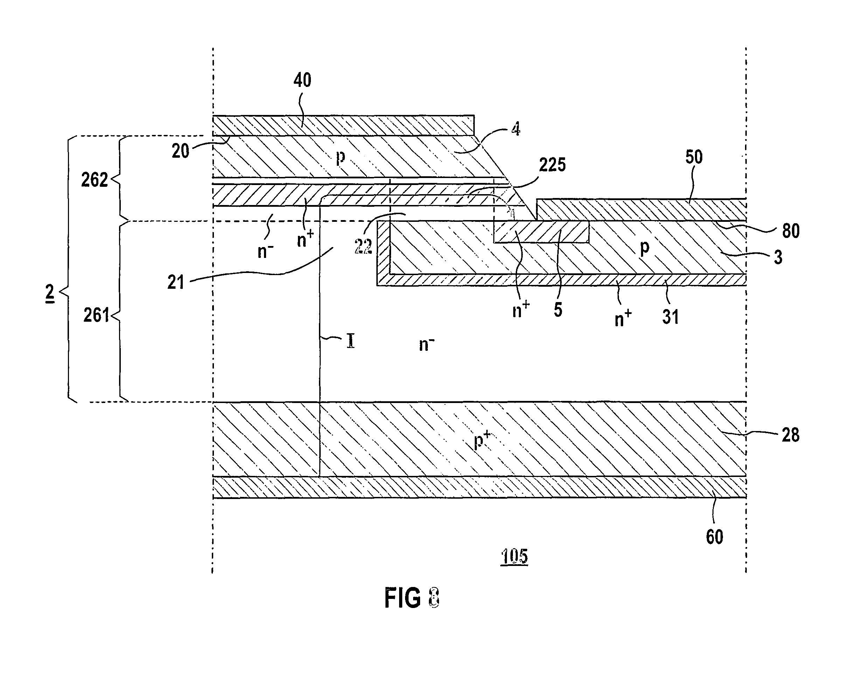

Neben den in den Figuren 1, 2, 4, 6 und 7 gezeigten Halbleiteraufbauten 100 bis 104 gibt es auch Ausführungsformen, bei denen anstelle des n-leitenden Substrats 27 ein p-leitendes Substrat 28 verwendet wird. In Figur 8 ist beispielhaft ein solcher Halbleiteraufbau 105 gezeigt. Es handelt sich um einen vertikalen JFET mit einem rückseitigen bipolaren Emitter (= BiFET). Das erste Halbleitergebiet 2 setzt sich dann nur aus den beiden n-leitenden Epitaxieschichten 261 und 262 zusammen und bildet mit dem p-leitenden Substrat 28 einen p-n-Übergang. Dieser zusätzliche p-n-Übergang ist insbesondere bei einem Einsatz bei einer hohen Spannung, die beispielsweise mindestens in der Größenordnung von einigen kV liegt, günstig.

Günstig ist weiterhin, dass im Durchlassbetrieb über den Kontakt 60 Löcher und über den Kontakt 50 Elektronen in den Halbleiteraufbau 105 injiziert werden. Dadurch kommt es zu einer starken Erhöhung der Ladungsträgerkonzentration. Diese bipolare Modulation der Ladungsträgerkonzentration führt zu einem besonders guten Stromleitungsverhalten.

Um zu verhindern, dass das p-leitende Inselgebiet 3 die von der Elektrode 60 aus injizierten Löcher direkt absaugt und sich infolge dessen die Konzentration der für den Stromtransport insbesondere unterhalb des Kanalleitungsgebiets 225 zur Verfügung stehenden Ladungsträger verringert, ist vorzugsweise ein stark n-leitendes Abschirmgebiet 31 zwischen dem ersten Halbleitergebiet 2 und dem Inselgebiet 3 vorgesehen. Das Abschirmgebiet 31 stellt eine wirksame Barriere gegen einen direkten Abfluss der injizierten Löcher in das Inselgebiet 3 dar. Dadurch bleibt unterhalb des Kanalleitungsgebiets 225 eine günstige hohe bipolare Ladungsträgerkonzentration erhalten.

Die Dotierstoffkonzentration des Abschirmgebiets 31 liegt typischerweise ein bis zwei Größenordnungen über der der ersten Epitaxieschicht 261. Im gezeigten Beispiel beträgt sie etwa 10¹⁷ cm⁻³. Das Abschirmgebiet 31 umgibt das Inselgebiet 3 insbesondere an den dem Substrat 28 und dem vertikalen Kanalgebiet 21 zugewandten Seiten. Diese vollständige Abschirmung ist jedoch nicht unbedingt erforderlich. Das Abschirmgebiet 31 kann auch nur bereichsweise unterhalb des Inselgebiets 3 vorgesehen sein.

Einen ähnlich positiven Abschirmeffekt wie das Abschirmgebiet 31 hat auch das Kanalleitungsgebiet 225. Es hindert die Löcher daran, in das p-leitende zweite Halbleitergebiet 4 abzufließen. Neben der verbesserten Modulation der Ladungsträgerkonzentration wird dadurch der Leckstrom über die Steuerelektrode 40 reduziert.

Die bei allen gezeigten Halbleiteraufbauten 100 bis 105 in den jeweiligen Gebieten vorgesehenen Leitungstypen können bei alternativen Ausführungsformen auch den jeweils entgegengesetzten Leitungstyp annehmen.

Bei jeder Ausführungsform wirkt sich das Kanalleitungsgebiet 225 günstig auf das Stromsteuerungsverhalten aus und führt insbesondere zu einem Herstellungsprozess, der weitgehend unabhängig von technologiebedingten Schwankungen ist. Damit lässt sich jeweils eine sehr hohe Ausbeute bei der Herstellung erzielen. Günstig ist außerdem, dass aufgrund der definierteren Einstellung der Kanaleigenschaften das jeweilige Kanalgebiet 22 mit einer geringeren Höhe ausgebildet werden kann. Ohne Einbuße in der Sperrspannungsfestigkeit kann dann auch die Kanallänge reduziert werden. Für die Sperrspannungsfestigkeit ist auch das Verhältnis von Kanallänge zu Kanalhöhe maßgeblich. Dieses Verhältnis ist größer als 1, vorzugsweise 5 und größer. Die Kanallänge ist bei den jeweiligen Halbleiteraufbauten 100 bis 105 mitbestimmend für den Platzbedarf und auch für den Widerstand im Durchlassbetrieb (= Rₒₙ). Beide Kenngrößen sinken also mit einer dank des Kanalleitungsgebiets 225 möglichen Reduzierung von Kanalhöhe und Kanallänge. Geringerer Platsbedarf ermöglicht eine höhere Zelldichte an Halbleiteraufbauten 100 bis 105, die auf einem Halbleiter-Wafer untergebracht werden können. Auch dadurch steigt die Ausbeute.

## Patentansprüche

1. Halbleiteraufbau zur Steuerung eines Stroms (I), aufweisend:
a) ein von dem zu steuernden Strom durchflossenes erstes Halbleitergebiet (2) eines ersten Leitungstyps (n- oder p-leitend);
b) ein innerhalb des ersten Halbleitergebiets (2) zumindest teilweise vergrabenes Inselgebiet (3) eines anderen, zweiten Leitungstyps (p- bzw. n-leitend);
c) ein laterales Kanalgebiet (22) zur Beeinflussung des Stromes (I) mittels mindestens einer Verarmungszone (23, 24), wobei das mit einer Grunddotierung versehene laterale Kanalgebiet (22)
c1) im ersten Halbleitergebiet (2) oberhalb des Inselgebiets (3) angeordnet ist,
c2) sich in einer Richtung parallel zu einer ersten Hauptoberfläche (20, 80) des ersten Halbleitergebiets (2) erstreckt und
c3) ein der Stromführung dienendes Kanalleitungsgebiet (225) des ersten Leitungstyps (n- oder p-leitend) aufweist und wobei das Kanalleitungsgebiet (225)
c4) eine höhere Dotierung besitzt als die Grunddotierung und
c5) es von Teilen des Kanalgebiets (22), welche die Grunddotierung aufweisen, in vertikaler Richtung beidseitig begrenzt ist.

2. Halbleiteraufbau nach Anspruch 1,
**dadurch gekennzeichnet, dass** der Strom (I) im Wesentlichen in vertikaler Richtung durch das erste Halbleitergebiet (2) fließt.

3. Halbleiteraufbau nach Anspruch 1 oder 2,
**dadurch gekennzeichnet, dass** ein erstes Kontaktgebiet (5) des ersten Leitungstyps (n- oder p-leitend) an der ersten Hauptoberfläche (20, 80) des ersten Halbleitergebiets (2) angeordnet oder in das Inselgebiet (3) eingebettet ist, dass eine erste Elektrode (50) das Inselgebiet (3) und das erste Kontaktgebiet (5) oder nur das erste Kontaktgebiet (5) kontaktiert, dass eine zweite Elektrode (60) auf einer zweiten Hauptoberfläche des ersten Halbleitergebiets (2) angeordnet ist, dass Mittel (40/4; 50/4) zur Erzeugung einer ersten Verarmungszone (24) derart vertikal oberhalb des Inselgebiets (3) angeordnet sind, dass sich diese in lateraler Richtung teilweise überlappen und dass das Kanalgebiet (22) sich innerhalb des Überlappungsbereichs der Mittel (40/4; 50/4) zur Erzeugung der ersten Verarmungszone (24) und des Inselgebiets (3) befindet.

4. Halbleiteraufbau nach einem der vorhergehenden Ansprüche,
**gekennzeichnet durch** ein Halbleitermaterial, dessen Bandabstand mindestens zwei Elektronenvolt beträgt.

5. Halbleiteraufbau nach einem der vorhergehenden Ansprüche,
**dadurch gekennzeichnet, dass** das Kanalleitungsgebiet (225) mindestens 80 % oder mindestens 90 % der im Kanalgebiet (22) vorhandenen Gesamtladung des ersten Leitungstyps (n- oder p-leitend) enthält.

6. Halbleiteraufbau nach einem der vorhergehenden Ansprüche,
**dadurch gekennzeichnet, dass** innerhalb des Kanalleitungsgebiets (225) des ersten Leitungstyps (n- oder p-leitend) mindestens ein Kanalkompensationsgebiet (226) des zweiten Leitungstyps (p- bzw. n-leitend) angeordnet ist,
wobei das Kanalkompensationsgebiet (226) eine höhere Dotierstoffkonzentration aufweist als das Kanalleitungsgebiet (225).

7. Halbleiteraufbau nach Anspruch 6,
**dadurch gekennzeichnet, dass** die in das Kanalleitungsgebiet (225) eingebrachte Gesamtladung des ersten Leitungstyps (n- oder p-leitend) annähernd gleich groß ist wie die in das Kanalkompensationsgebiet (226) eingebrachte Gesamtladung des zweiten Leitungstyps (p- bzw. n-leitend).

8. Halbleiteraufbau nach einem der vorhergehenden Ansprüche,
**dadurch gekennzeichnet, dass** das Kanalgebiet (22) in einer die Grunddotierung aufweisenden Epitaxieschicht (262) angeordnet ist.

9. Halbleiteraufbau nach einem der vorhergehenden Ansprüche,
**dadurch gekennzeichnet, dass** das erste Halbleitergebiet (2) zwei Epitaxieschichten (261, 262) mit im Wesentlichen gleicher Dotierung aufweist.

10. Halbleiteraufbau nach einem der vorhergehenden Ansprüche,
**dadurch gekennzeichnet, dass** das erste Halbleitergebiet (2) auf einem Substrat (28) des zweiten Leitungstyps (p- bzw. n-leitend) angeordnet ist und der Strom (I) auch durch das Substrat (28) fließt.

11. Halbleiteraufbau nach Anspruch 10,
**gekennzeichnet durch** ein Abschirmgebiet (31) des ersten Leitungstyps (n- oder p-leitend), welches zumindest auf einer dem Substrat (28) zugewandten Seite des Inselgebiets (3) zwischen dem Inselgebiet (3) und dem ersten Halbleitergebiet (2) angeordnet ist.

12. Verfahren zur Herstellung eines Halbleiteraufbaus nach Patentanspruch 1 durch das Ausführen folgender Schritte:
a) Aufbringen einer eine Grunddotierung aufweisenden ersten Epitaxieschicht (261) eines ersten Leitungstyps (n- oder p-leitend) auf ein Halbleitersubstrat (27);
b) Erzeugung eines Inselgebiets (3) eines zweiten Leitungstyps (p- bzw. n-leitend) in der ersten Epitaxieschicht (261);
c) Aufbringen einer im Wesentlichen die Grunddotierung aufweisenden zweiten Epitaxieschicht (262) des ersten Leitungstyps (n- oder p-leitend) auf der ersten Epitaxieschicht (261);
d) Teilweises Freilegen des Inselgebiets (3) durch selektives Entfernen der zweiten Epitaxieschicht (262);
e) Erzeugung eines eine höhere Dotierung als die Grunddotierung aufweisenden, sich parallel zu einer Hauptfläche der ersten Epitaxieschicht (261) erstreckenden Kanalleitungsgebietes (225) des ersten Leitungstyps (n- oder p-leitend) innerhalb der zweiten Epitaxieschicht (262) mittels Ionenimplantation derart, dass das Kanalleitungsgebiet (225) von Teilen der zweiten Epitaxieschicht (262), welche die Grunddotierung aufweisen, beidseitig in vertikaler Richtung begrenzt ist.

## Claims

1. Semiconductor construction for controlling a current (I) having:
a) a first semiconductor region (2) of a first conduction type (n-or p-conducting), the current to be controlled flowing through said first semiconductor region;
b) an island region (3) of a different, second conduction type (p- or n-conducting, respectively), said island region being at least partially buried within the first semiconductor region (2),
c) a lateral channel region (22) for influencing the current (I) by means of at least one depletion zone (23, 24), wherein the lateral channel region (22) provided with a basic doping
c1) is arranged in the first semiconductor region (2) above the island region (3),
c2) extends in a direction parallel to a first main surface (20, 80) of the first semiconductor region (2) and
c3) has a channel conduction region (225) serving for carrying current and being of the first conduction type (n- or p-conducting), and wherein the channel conduction region (225)
c4) has a higher doping than the basic doping and
c5) is delimited on both sides in a vertical direction by parts of the channel region (22) which have the basic doping.

2. Semiconductor construction according to Claim 1, **characterized in that** the current (I) essentially flows in the vertical direction through the first semiconductor region (2).

3. Semiconductor construction according to Claim 1 or 2, **characterized in that** a first contact region (5) of the first induction type (n- or p-conducting), is arranged on the first main surface (20, 80) of the first semiconductor region (2) was embedded into the island region (3), **in that** a first electrode (50) makes contact with the island region (3) and the first contact region (5) or only the first contact region (5), **in that** a second electrode (60) is arranged on a second main surface of the first semiconductor region (2), **in that** means (40/4; 50/4) for producing a first depletion zone (24) are arranged vertically above the island region (3) in such a way that they partially overlap in a lateral direction, and **in that** the channel region (22) is situated within the overlap region of the means (40/4; 50/4) for producing the first depletion zone (24) and the island region (3).

4. Semiconductor construction according to one of the preceding claims, **characterized in that** a semiconductor material having a band gap of at least two electronvolts.

5. Semiconductor construction according to one of the preceding claims, **characterized in that** the channel conduction region (225) contains at least 80% or at least 90% of the total charge of the first conduction type (n- or p-conducting) present in the channel region (22).

6. Semiconductor construction according to one of the preceding claims, **characterized in that** at least one channel compensation region (226) of the second conduction type (p- or n-conducting) is arranged within the channel conduction region (225) of the first conduction type (n- or p-conducting, respectively), the channel compensation region (226) having a higher dopant concentration than the channel conduction region (225).

7. Semiconductor construction according to Claim 6, **characterized in that** the total charge of the first conduction type (n- or p-conducting) introduced into the channel conduction region (225) is approximately equal in magnitude to the total charge of the second conduction type (p- or n-conducting, respectively) introduced into the channel compensation region (226).

8. Semiconductor construction according to one of the preceding claims, **characterized in that** the channel region (22) is arranged in an epitaxial layer (262) having the basic doping.

9. Semiconductor construction according to one of the preceding claims, **characterized in that** the first semiconductor region (2) has two epitaxial layers (261, 262) having an essentially identical doping.

10. Semiconductor construction according to one of the preceding claims, **characterized in that** the first semiconductor region (2) is arranged on a substrate (28) of the second conduction type (p- or n-conducting), and the current (I) also flows through the substrate (28).

11. Semiconductor construction according to Claim 10, **characterized by** a shielding region (31) of the first conduction type (n- or p-conducting), said shielding region being arranged between the island region (3) and the first semiconductor region (2) at least on a side of the island region (3) that faces the substrate (28).

12. Method for producing a semiconductor construction according to Claim 1, by carrying out the following steps:
a) applying a first epitaxial layer (261) having a basic doping and being of a first conduction type (nor p-conducting), to a semiconducting substrate (27);
b) producing an island region (3) of a second conduction type (p- or n-conducting, respectively) in the first epitaxial layer (261);
c) applying a second epitaxial layer (262) essentially having the basic doping and being of the first conduction type (n- or p-conducting) on the first epitaxial layer (261);
d) partially uncovering the island region (3) by selectively removing the second epitaxial layer (262);
e) producing a channel conduction region (225) having a higher doping than the basic doping, extending parallel to a main area of the first epitaxial layer (261) and being of the first conduction type (n- or p-conducting) within the second epitaxial layer (262) by means of ion implantation in such a way that the channel conduction region (225) is delimited on both sides in a vertical direction by parts of the second epitaxial layer (262) which have the basic doping.

## Revendications

1. Structure à semiconducteur pour la commande d'un courant (I), comportant :
a) une première zone (2) semiconductrice d'un premier type de conduction (à conductivité n ou p) parcourue par le courant à commander ;
b) un îlot (3) d'un autre deuxième type de conduction (à conductivité p ou n) enterré au moins en partie au sein de la première zone (2) semiconductrice ;
c) une zone (22) latérale de canal pour influencer le courant (I) au moyen d'au moins une zone (23, 24) d'appauvrissement, la zone (22) latérale de canal étant pourvue d'un dopage de base
c1) étant disposée dans la première zone (2) semiconductrice au-dessus de l'îlot (3),
c2) s'étendant dans une direction parallèle à une première surface (20, 80) principale de la première zone (2) semiconductrice et
c3) ayant une zone (225) de conduction de canal servant au passage du courant du premier type de conduction (à conductivité n ou p) et dans lequel la zone (22) de conduction de canal
c4) a un dopage plus grand que le dopage de base et
c5) est délimitée des deux côtés dans la direction verticale par des parties de la zone (22) de canal, qui comportent le dopage de base.

2. Structure à semiconducteur suivant la revendication 1, **caractérisée en ce que** le courant (I) passe dans la première zone (2) semiconductrice essentiellement dans la direction verticale.

3. Structure à semiconducteur suivant la revendication 1 ou 2, **caractérisée en ce qu'**une première zone (5) de contact du premier type de conduction (à conductivité n ou p) est disposée sur la première surface (20, 80) principale de la première zone (2) semiconductrice ou est incorporée dans l'îlot (3), **en ce qu'**une première électrode (50) est en contact avec l'îlot (3) et avec la première zone (5) de contact ou seulement avec la première zone (5) de contact, **en ce qu'**une deuxième électrode (60) est disposée sur une deuxième surface principale de la première zone (2) semiconductrice, **en ce que** des moyens (40/4 ; 50/4) de production d'une première zone (24) d'appauvrissement sont disposés verticalement au-dessus de l'îlot (3), de manière à se chevaucher en partie dans la direction latérale, et **en ce que** la zone (22) de canal se trouve à l'intérieur de la zone de chevauchement des moyens (40/4 ; 50/4) de production de la première zone (24) d'appauvrissement et de l'îlot (3).

4. Structure à semiconducteur suivant l'une des revendications précédentes,
**caractérisée par** un matériau semiconducteur dont la bande interdite est d'au moins deux électronvolt.

5. Structure à semiconducteur suivant l'une des revendications précédentes,
**caractérisée en ce que** la zone (225) de conduction de canal contient au moins 80% ou au moins 90% de toute la charge présente dans la zone (22) de canal du premier type de conduction (à conductivité n ou p).

6. Structure à semiconducteur suivant l'une des revendications précédentes,
**caractérisée en ce qu'**au sein de la zone (225) de conduction de canal du premier type de conduction (à conductivité n ou p) est disposée au moins une zone (226) de compensation de canal du deuxième type de conduction (à conductivité p ou n), la zone (226) de compensation de canal ayant une concentration de substance de dopage plus grande que la zone (225) de conduction de canal.

7. Structure à semiconducteur suivant la revendication 6, **caractérisée en ce que** toute la charge introduite dans la zone (225) de conduction de canal du premier type de conduction (à conductivité n ou p) est à peu près égale à toute la charge introduite dans la zone (226) de compensation de canal du deuxième type de conduction (à conductivité p ou n).

8. Structure à semiconducteur suivant l'une des revendications précédentes,
**caractérisée en ce que** la zone (22) de canal est disposée dans une couche (262) épitaxiale ayant le dopage de base.

9. Structure à semiconducteur suivant l'une des revendications précédentes,
**caractérisée en ce que** la première zone (2) semiconductrice a deux couches (261, 262) épitaxiales ayant sensiblement le même dopage.

10. Structure à semiconducteur suivant l'une des revendications précédentes,
**caractérisée en ce que** la première zone (2) semiconductrice est disposée suivant un substrat (28) du deuxième type de conduction (à conductivité p ou n) et le courant (I) passe aussi dans le substrat (28).

11. Structure à semiconducteur suivant la revendication 10, **caractérisée par** une zone (31) d'écran du premier type de conduction (à conductivité n ou p), qui est placée au moins d'un côté, tourné vers le substrat (28), de l'îlot (3) entre l'îlot (3) et la première zone (2) semiconductrice.

12. Procédé de production d'une structure à semiconducteur suivant la revendication 1 en exécutant les stades suivants :
a) on dépose une première couche (261) épitaxiale ayant un dopage de base d'un premier type de conduction (à conductivité n ou p) sur un substrat (27) semiconducteur ;
b) on produit un îlot (3) d'un deuxième type de conduction (à conductivité p ou n) dans la première couche (261) épitaxiale ;
c) on dépose une deuxième couche (262) épitaxiale ayant sensiblement le dopage de base du premier type de conduction (à conductivité n ou p) sur la première couche (261) épitaxiale ;
d) on dénude en partie l'îlot (3) par élimination sélective de la deuxième couche (262) épitaxiale ;
e) on produit une zone (225) de conduction de canal du premier type de conduction (à conductivité n ou p) ayant le dopage de base et s'étendant parallèlement à une surface principale de la première couche (261) épitaxiale au sein de la deuxième couche (262) épitaxiale au moyen d'une implantation d'ion, de manière à délimiter des deux côtés dans la direction verticale la zone (225) de conduction de canal par des parties de la deuxième couche (262) épitaxiale qui ont le dopage de base.
